# FASCICULE DE BREVET EUROPEEN

(11) **EP 3 811 423 B1**
(45) Date de publication et mention de la délivrance du brevet: **17.08.2022**
(21) Numéro de dépôt: 19742431.0
(22) Date de dépôt: 14.05.2019
(51) Int. Cl.: H01L 33/62, H01L 23/498

(54) **PUCE PHOTONIQUE COMPORTANT UNE SOURCE LASER ENTERRÉE**
PHOTONISCHER CHIP MIT VERGRABENER LASERQUELLE
PHOTONIC CHIP WITH BURIED LASER SOURCE

(30) Priorité: 08.06.2018 FR 1855010
(43) Date de publication de la demande: 28.04.2021
(73) Titulaire: Commissariat à l'Énergie Atomique et aux Énergies Alternatives, 75015 Paris (FR)
(72) Inventeur: MENEZO, Sylvie, 38054 Grenoble Cedex 9 (FR); CHERAMY, Séverine, 38054 Grenoble Cedex 9 (FR)
(74) Mandataire: INNOV-GROUP
(86) Numéro de dépôt international: PCT/FR2019/051082
(87) Numéro de publication internationale: WO 2019/234323

(56) Documents cités:
- FR-A1- 3 023 066
- US-A1- 2003 038 344
- US-A1- 2009 296 367
- US-A1- 2011 248 397
- US-A1- 2012 155 055
- US-A1- 2016 141 467
- YAN YANG ET AL: "Through-Si-via (TSV) Keep--out-Zone (KOZ) in SOI Photonics Interposer: A study of the impact of TSV-Induced Stress on Si Ring Resonators", IEEE PHOTONICS JOURNAL,, vol. 5, no. 6, 13 décembre 2013 (2013-12-13), XP002788522, cité dans la demande
- DUREL J ET AL: "First demonstration of a back-side integrated heterogeneous hybrid III-V/Si DBR lasers for Si-photonics applications", 2016 IEEE INTERNATIONAL ELECTRON DEVICES MEETING (IEDM), IEEE, 3 décembre 2016 (2016-12-03), XP033055031, DOI: 10.1109/IEDM.2016.7838471 [extrait le 2017-01-31]

## Description

L'invention concerne une puce photonique comportant une source laser enterrée ainsi qu'un procédé de fabrication d'une telle puce photonique.

Les puces photoniques s'étendent essentiellement dans un plan appelé par la suite « plan de la puce ».

Des puces photoniques connues comportent :
- un substrat présentant des faces supérieure et inférieure parallèles au plan de la puce, ce substrat comportant, entre les faces supérieure et inférieure :
   - un support d'épaisseur supérieure à 50 µm, ce support étant dépourvu de composant optique,
   - une couche optique collée, au niveau d'une interface de collage, sur le support, cette couche optique comportant successivement, en allant de la face supérieure vers l'interface de collage :
      - une sous-couche d'oxyde, et
      - une sous-couche d'encapsulation,
   - une source laser enterrée à l'intérieur de la couche optique, cette source laser comportant un guide d'onde réalisé sur le côté de la sous-couche d'oxyde tourné vers l'interface de collage et encapsulé dans un matériau diélectrique de la couche d'encapsulation, ce guide d'onde comportant un premier contact électrique enfoui à l'intérieur de la sous-couche d'encapsulation.

Une telle puce photonique est par exemple décrite dans l'article suivant : J.Durel et Al : "First Démonstration of a Back-Side Integrated Heterogeneous Hybrid III-V/Si DBR Lasers for Si-Photonics Applications", IEEE International Electron Devices Meeting (IEDM), Décembre 2016.

Cette puce présente l'avantage d'être particulièrement simple à fabriquer. Toutefois, il est souhaitable, tout en conservant cet avantage, de la perfectionner encore plus pour améliorer la dissipation thermique de la chaleur générée par la source laser lorsqu'elle fonctionne. A cet effet, l'invention concerne une telle puce photonique dans laquelle la puce photonique comporte un réseau de métal d'interconnexion formant un via qui s'étend, à l'intérieur de la couche optique, depuis l'interface de collage jusqu'au premier contact électrique enfoui du guide d'onde, ce réseau de métal d'interconnexion comportant des via métalliques qui raccordent électriquement entre-elles des lignes de métal qui s'étendent principalement parallèlement au plan de la puce, ces lignes de métal étant disposées les une au-dessus des autres à l'intérieur de la couche optique. US2012155055 divulgue un substrat ayant une structure d'interconnexion verticale, comprenant des vias et des lignes métalliques

Les modes de réalisation de cette puce photonique peuvent comporter une ou plusieurs des caractéristiques des revendications dépendantes.

L'invention a également pour objet un procédé de fabrication de la puce photonique, objet de la présente demande.

L'invention sera mieux comprise à la lecture de la description qui va suivre. Elle est donnée uniquement à titre d'exemple non limitatif tout en se référant aux dessins sur lesquels :
- la figure 1 est une illustration schématique d'un système comportant une puce photonique ;
- la figure 2 est une illustration schématique, en coupe verticale, de la puce photonique du système de la figure 1 ;
- la figure 3 est une illustration schématique et partielle, en coupe verticale, de la section transversale d'un guide d'onde de la puce photonique du système de la figure 1;
- la figure 4 est un organigramme d'un procédé de fabrication du système de la figure 1 ;
- les figures 5 à 11 sont des illustrations schématiques, en coupe verticale, de différents états de fabrication de la puce photonique de la figure 2 ;
- la figure 12 est une illustration schématique, en coupe verticale, d'une première variante de la puce photonique de la figure 2 ;
- la figure 13 est une illustration schématique, en coupe verticale, d'une deuxième variante de la puce photonique de la figure 2.

Dans ces figures, les mêmes références sont utilisées pour désigner les mêmes éléments. Dans la suite de cette description, les caractéristiques et les fonctions bien connues de l'homme du métier ne sont pas décrites en détail.

### Chapitre I : Exemples de modes de réalisation

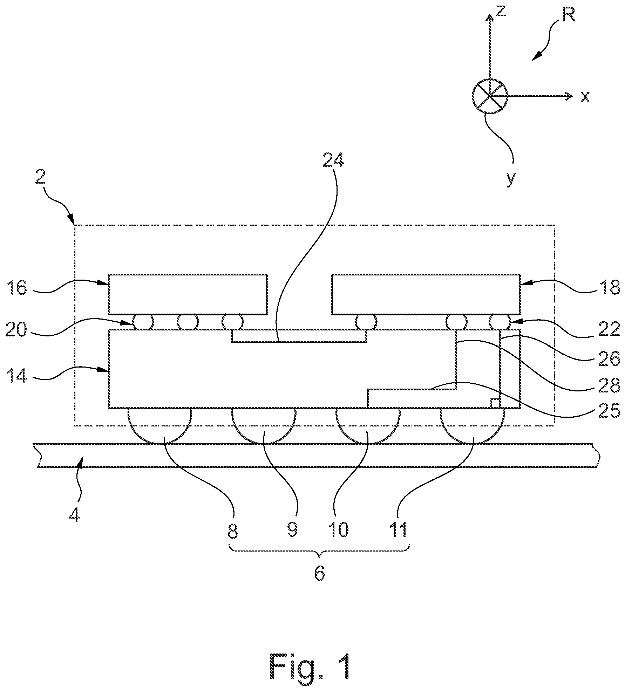

La figure 1 représente une portion d'un système 2 soudé sur un circuit imprimé 4 ou PCT (« Printed Circuit Board ») par l'intermédiaire d'un réseau 6 de billes de soudure (en anglais, « Solder bumps »). Pour simplifier l'illustration, seules quatre billes 8 à 11 du réseau 6 sont représentées.

Le système 2 se présente typiquement sous la forme d'un boîtier parallélépipédique à l'intérieur duquel sont logés des puces électroniques et optiques. Seules les billes de soudure du système 2 font saillie sur une face inférieure de ce boîtier. Pour simplifier l'illustration, ce boîtier n'a pas été représenté sur la figure 1. Le système 2 dans son boîtier est connu sous le nom anglais de 'system in package'. De façon plus générique, le système 2 est aussi souvent désigné par le terme « circuit-intégré ».

Dans la suite de cette description, l'horizontal est défini sur les figures par des directions X et Y d'un repère orthogonal R. La direction Z du repère R correspond à la direction verticale. Les termes tels que « inférieur », « supérieur », « dessus », « dessous », « haut » et « bas » sont définis par rapport à cette direction Z.

Dans sa partie inférieure, le système 2 comporte un support 14. Les billes du réseau 6 sont placées directement sur la face inférieure du support 14. L'ensemble du support 14 et du réseau 6 est connu sous l'acronyme BGA (« Ball Grid Array »). La face supérieure du support 14 comporte des plots sur lesquels des puces électroniques et/ou photoniques peuvent être soudées. Dans le cas particulier de la figure 1, le système 2 comporte une puce électronique 16 et une puce photonique 18. Ces deux puces 16 et 18 sont toutes les deux directement soudées sur la face supérieure du support 14.

La puce électronique comporte uniquement des composants électroniques raccordés les uns aux autres pour réaliser des fonctions prédéterminées. La puce électronique 16 est donc dépourvue de composant optique.

A l'inverse, la puce photonique 18 comporte des composants optiques pour remplir des fonctions prédéterminées. Un composant optique est un composant qui, au cours de son utilisation, génère ou modifie ou guide un signal optique. Typiquement, la longueur d'onde λ du signal optique est comprise entre 1200 nm et 1700 nm. Généralement, au moins un de ces composants optiques est un composant optique actif, c'est-à-dire un composant optique :
- qui doit être alimenté par un courant ou une tension électrique pour fonctionner correctement, et/ou
- qui convertit un signal optique en un signal électrique (cas d'un photo-détecteur), ou convertit un signal électrique en un signal optique (cas d'un modulateur de lumière).

Dans ce mode de réalisation, la puce photonique 18 est dépourvue de composant électronique.

Pour être alimentées en électricité ou pour échanger des signaux électriques, la puce photonique 18 et la puce électronique 16 du système 2 sont électriquement raccordées à des plots de la face supérieure du support 14. Les puces 16 et 18 sont également raccordées électriquement au circuit imprimé 4. A cet effet, ici, les puces 16 et 18 sont soudées sur des plots respectifs de la face supérieure du support 14 par l'intermédiaire de réseaux, respectivement 20 et 22, de microbilles de soudure. Sur la figure 1, les réseaux 20 et 22 sont représentés par quelques-unes de ces microbilles de soudure situées sous les puces 16 et 18. Par exemple, les microbilles de soudure sont connues sous le terme anglais de « C4 Bumps ».

Le support 14 comporte des connexions électriques qui s'étendent principalement horizontalement, telle qu'une connexion 24. La connexion 24 relie électriquement certains plots de la face supérieure du support 14 entre eux afin de permettre l'échange de signaux électriques ou d'alimentation électrique entre les puces soudées sur ces plots. Le support 14 est aussi traversé par des connexions verticales, telles que des connexions 26 et 28. Généralement, ces connexions verticales débouchent sur une ligne de métal horizontale d'une couche de redistribution plus connue sous l'acronyme RDL (« Redistribution layer »). Ici, une seule ligne 25 de cette couche de redistribution est illustrée. Les lignes horizontales de la couche de redistribution relient électriquement certaines des connexions verticales à des billes de soudure correspondantes du réseau 6. Les connexions verticales permettent notamment d'alimenter électriquement les puces 16 et 18 et, aussi, d'échanger des signaux électriques avec d'autres puces soudées sur le circuit imprimé 4. En dehors des connexions horizontales et verticales, le support 14 est généralement dépourvu de tout autre composant électrique ou optique.

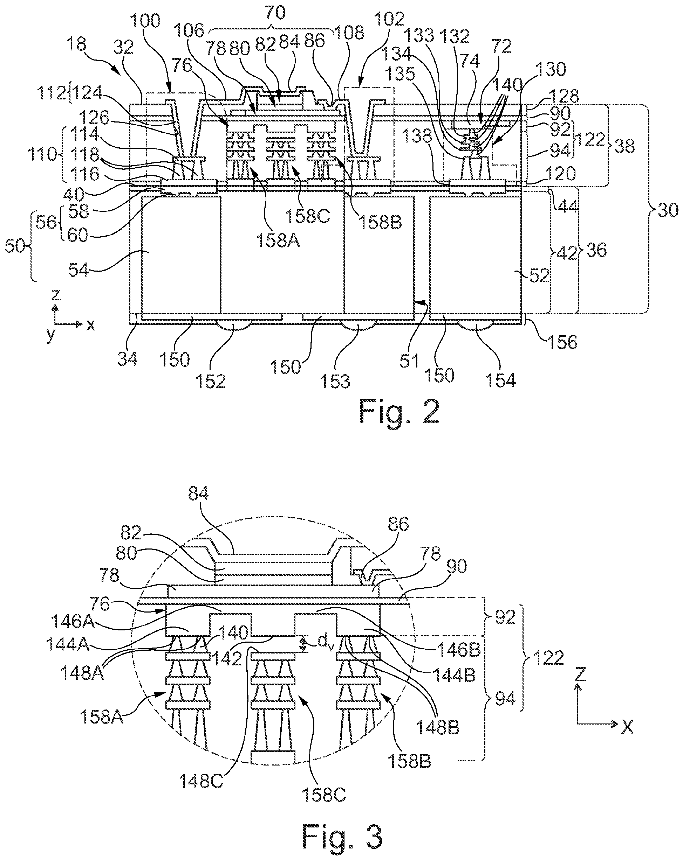

La figure 2 représente plus en détail une portion de la puce photonique 18. La puce 18 comporte un substrat 30 présentant une face supérieure horizontale 32 et une face inférieure horizontale 34. Entre ces faces 32 et 34, le substrat 30 comporte, directement empilées l'une sur l'autre, en allant du bas vers le haut :
- une couche 36 d'interconnexion, et
- une couche optique 38.

Plus précisément, les couches 36 et 38 sont directement collées l'une sur l'autre au niveau d'une interface 40 de collage qui s'étend essentiellement dans un plan horizontal. La face supérieure de la couche 38 correspond à la face supérieure 32 et la face inférieure de la couche 36 correspond à la face inférieure 34.

La couche 36 est principalement réalisée dans un matériau non-conducteur. Dans cette description, on désigne par « matériau non-conducteur » un matériau dont la conductivité à 20°C est inférieure à 10⁻¹ ou 10⁻² S/m. Ainsi, ce matériau non-conducteur peut être un matériau semi-conducteur tel que le silicium non dopé ou un matériau électriquement isolant tel que le verre. Un matériau électriquement isolant est un matériau dont la conductivité à 20°C est inférieure à 10⁻⁹ S/m et, de préférence, inférieure à 10⁻¹⁵ S/m ou 10⁻¹⁶ S/m. Par la suite un matériau électriquement isolant est également appelé "matériau diélectrique". Ici, le matériau non-conducteur est du silicium cristallin non dopé. A l'inverse, dans cette description, on désigne par « matériau conducteur » ou « matériau électriquement conducteur » un matériau dont la conductivité électrique à 20°C est généralement supérieure à 10⁵ ou 10⁶ S/m.

Ici, la couche 36 comporte une sous-couche 42 en silicium cristallin non dopé et une sous-couche superficielle 44 réalisée directement sur la sous-couche 42. Ici la sous-couche 44 est réalisée en dioxyde de silicium.

La face inférieure de la sous-couche 42 correspond à la face 34. L'épaisseur de la sous-couche 42 est assez importante pour être assez rigide et ne pas présenter une flèche trop importante. En particulier, l'épaisseur de la sous-couche 42 est suffisante pour permettre de manipuler la puce 18. Ainsi, la couche 36 forme un support pour la couche optique 38. A cet effet, l'épaisseur de la sous-couche 42 est supérieure à 50 µm ou à 80 µm ou à 100 µm.

La sous-couche 42 comporte des via, appelés par la suite « via primaires » qui permettent de former des connexions électriques qui traversent verticalement le substrat 30. Chaque via primaire s'étend depuis une extrémité inférieure jusqu'à une extrémité supérieure. L'extrémité inférieure affleure la face inférieure 34. L'extrémité supérieure affleure l'interface 40 de collage. Ces via primaires traversent donc la totalité de l'épaisseur de la couche 36 d'interconnexion. Par contre, les via primaires ne traversent pas et ne pénètrent pas à l'intérieur de la couche optique 38.

La couche 36 ne contient pas de couche d'oxyde de silicium enterré. Son épaisseur minimale donnant lieu à une flèche acceptable est donc moindre que celle d'une couche qui contiendrait une telle couche d'oxyde de silicium enterré. Avoir une épaisseur moindre permet notamment de diminuer les capacités parasites des via primaires qui est proportionnelle à la hauteur des via primaires. Ainsi, de préférence, l'épaisseur de la sous-couche 42 est également inférieure à 150 µm ou 100 µm.

La figure 2 représente seulement trois via primaires 50 à 52. Toutefois, en général, la couche 36 comporte un nombre bien plus important de via primaires. Par exemple, tous les via primaires sont structurellement identiques de sorte que par la suite, seul le via primaire 50 est décrit plus en détail.

Le via primaire 50 est réalisé de façon conventionnelle. Par exemple, à ce sujet, le lecteur peut consulter l'article suivant : Ken Miyairi et Al : « Full intégration and electrical characterization of 3D Silicon Interposer demonstrator incorporating high density TSVs and interconnects », 45th International Symposium on Microelectronics, 2012. Ainsi, par la suite seuls quelques détails du via 50 sont décrits.

Dans ce mode de réalisation, le via 50 est formé, en allant du bas vers le haut :
- d'une partie inférieure 54 en forme de barreau vertical, et
- d'une partie supérieure 56 en forme de réseau de métal d'interconnexion.

La partie inférieure 54 s'étend verticalement de l'extrémité inférieure du via 50 jusqu'à la partie supérieure 56. La section horizontale de la partie inférieure est sensiblement constante sur toute sa hauteur. Sa hauteur et son diamètre sont par la suite notés, respectivement, H1 et D1. La partie inférieure 54 traverse au moins 80 % et, de préférence, au moins 90 % ou 95 % de l'épaisseur de la couche 36. Étant donné que l'épaisseur de la couche 36 est importante, le diamètre D1 est également important pour que le rapport de forme H1/D1 soit inférieur à 10/1 ou 8/1. En effet, il est difficile de fabriquer des via ayant un rapport de forme supérieur à 10/1. Ici, la hauteur H1 est supérieure à 80 % ou 90 % ou 95 % de l'épaisseur de la sous-couche 42. Dans ces conditions, la hauteur H1 est comprise entre 80 µm et 142,5 µm et, généralement, comprise entre 95 µm et 130 µm. Le diamètre D1 est alors typiquement compris entre 10 µm et 20 µm. Dans le cas où la sous-couche 42 est réalisée dans un matériau semi-conducteur comme du silicium, de préférence, la partie inférieure 54 est électriquement isolée de ce matériau semi-conducteur par une fin revêtement en matériau électriquement isolant. Pour simplifier les figures, ce revêtement en matériau électriquement isolant n'a pas été représenté. La partie inférieure 54 est réalisée en métal et, par exemple, en cuivre.

La partie supérieure 56 du via 50 est formée par un réseau de métal d'interconnexion. Cette partie supérieure 56 se compose donc :
- de lignes de métal qui s'étendent principalement horizontalement, et
- de via métalliques qui raccordent électriquement entre elles ces lignes de métal.

On rappelle qu'un "via" est une connexion électrique verticale, c'est-à-dire qui s'étend principalement dans une direction perpendiculaire au plan de la puce photonique.

Les lignes de métal et, de préférence, les via métalliques sont réalisées dans la sous-couche 44 d'oxyde de silicium. Ici, la partie supérieure 56 comporte :
- une ligne de métal 58 qui affleure l'interface 40 de collage, et
- des via métalliques 60 qui raccordent cette ligne 58 directement au sommet de la partie inférieure 54.

Dans cette description, par « via métallique », on désigne un via réalisé en métal et dont le diamètre est généralement petit, c'est-à-dire dont le diamètre est inférieur à 3 µm et, souvent, inférieur à 1 µm. La hauteur d'un via métallique est également petite, c'est-à-dire inférieure à 3 µm ou 1 µm.

Ici, le métal est du cuivre. La structure d'un tel réseau de métal d'interconnexion est bien connue de l'homme du métier. Il s'agit de réseau de métal d'interconnexion de la couche de redistribution ou RDL.

L'épaisseur de la sous-couche 44 est typiquement inférieure à 10 µm ou 3 µm.

Le diamètre de la partie supérieure 56 est égal au plus grand diamètre d'un via métallique qui la compose. Ici, le diamètre de la partie supérieure 56 est donc inférieur à 10 µm et, généralement, inférieur à 3 µm ou à 1 µm.

La couche optique 38 comporte au moins un composant optique enterré à l'intérieur de cette couche. Ici, le composant optique est choisi dans le groupe constitué d'un modulateur optique, d'une source laser, d'un guide d'onde, d'un photodétecteur, d'un démultiplexeur et d'un multiplexeur optique. Parmi les composants optiques de ce groupe, tous sont des composants optiques actifs à l'exception du guide d'onde.

Dans cet exemple de réalisation, seuls deux composants optiques 70, 72 enterrés dans la couche 38 sont représentés. Le composant 70 est une source laser et le composant 72 est un modulateur optique. Le composant 72 est capable de modifier, en fonction d'un signal électrique de commande, la phase, l'amplitude ou l'intensité d'un signal optique qui le traverse. De tels modulateurs optiques sont bien connus de sorte que le composant 72 n'est pas décrit ici en détail. Le composant 72 comporte un contact électrique 74 destiné à recevoir le signal électrique de commande. Ici, ce contact électrique 74 est enfoui à l'intérieur de la couche optique 38. Dans ce mode de réalisation, le contact électrique 74 est situé sur une face inférieure du composant 72. Le contact électrique 74 est donc tourné vers l'interface 40 de collage. Dans cette configuration, le contact électrique 74 est uniquement accessible par le dessous du composant optique 72.

Le composant 70 est une source laser hétérogène III-V/Silicium. Le composant 70 est par exemple une source laser connue sous l'acronyme DFB (« Distributed Feedback Laser ») ou DBR (« Distributed Bragg Reflector Laser »). Une telle source laser est bien connue de l'homme du métier et n'est donc pas décrite en détail ici. Ici, le composant 70 comporte notamment, un guide d'onde 76 et, empilées directement les unes sur les autres :
- une couche inférieure 78 en matériau semi-conducteur présentant un dopage N,
- une couche active 80, et
- une couche supérieure 82 en matériau semi-conducteur présentant un dopage P.

Le composant 70 comporte également une prise supérieure 84 et une prise inférieure 86 directement en contact, respectivement, avec les couches supérieure 82 et inférieure 78.

La couche active 80 génère le signal optique émis par le composant 70 lorsqu'une différence de potentiels appropriée est appliquée entre les prises 84 et 86.

Ici, la couche inférieure 78 est couplée optiquement au guide d'onde 76. Pour cela, la couche 78 est disposée au-dessus du guide d'onde 76 et séparée de ce guide d'onde 76 par une mince sous-couche 90 d'oxyde enterré. Par exemple, la sous-couche 90 est réalisée en dioxyde de silicium. L'épaisseur de la sous-couche d'oxyde 90 est inférieure à 100 nm et, de préférence, inférieure à 50 nm ou 20 nm. Ainsi, le signal optique généré par la couche active 80 peut ensuite être guidé par le guide d'onde 76.

Dans ce mode de réalisation, le guide d'onde 76 comporte :
- une nervure centrale 142 (Figure 3),
- deux excroissances 144A et 144B (Figure 3) s'étendant parallèlement à la nervure centrale 142, et
- deux rebords 146A et 146B (Figure 3) qui relient mécaniquement et thermiquement la nervure centrale 142, respectivement, aux excroissances 144A et 144B.

L'épaisseur e₁₄₂, dans la direction Z, de la nervure centrale 142 est généralement inférieure à 1 µm et, de préférence, inférieure à 500 nm. Ici, la section transversale de la nervure 142 est rectangulaire de sorte qu'elle présente deux parois verticales parallèles.

Les excroissances 144A et 144B sont situées de part et d'autre de la nervure 142. Ici, la section transversale de chacune de ces excroissances 144A, 144B est rectangulaire de sorte qu'elles présentent chacune aussi des parois verticales. La face supérieure de chacune des excroissances 144A, 144B est directement en contact mécanique avec la sous-couche 90. L'épaisseur, dans la direction Z, des excroissances 144A et 144B est égale ou inférieure à l'épaisseur de la nervure 142. Ici, l'épaisseur des excroissances 144A, 144B est égale à l'épaisseur de la nervure 142.

Les rebords 146A et 146B sont situés chacun d'un côté respectif de la nervure 142. Ces rebords s'étendent, parallèlement à la direction X, depuis une paroi verticale de la nervure 142 jusqu'à une paroi verticale en vis-à-vis de l'une des excroissances 144A, 144B. La face supérieure de chaque rebord 146A, 146B est directement en contact mécanique avec la sous-couche 90. L'épaisseur e₁₄₆ de chaque rebord 146A, 146B est inférieure à l'épaisseur e₁₄₂ de la nervure 142 de manière à confiner le signal optique guidé principalement à l'intérieur de la nervure 142. A cet effet, l'épaisseur e₁₄₆, dans la direction Z, des rebords 146A, 146B est généralement inférieure à 0,5e₁₄₂ ou à 0,33e₁₄₂. Pour faciliter la conduction de la chaleur depuis la nervure 142 vers les excroissances 144A, 144B, l'épaisseur e₁₄₆ est également généralement choisie supérieure à 0,1e₁₄₂ ou 0,2e₁₄₂.

La nervure 142, les excroissances 144A, 144B et les rebords 146A, 146B sont réalisés dans le même matériau de sorte que la réunion de ces différentes parties du guide d'onde 76 ne forme qu'un seul bloc de matière. Ici, le guide d'onde 76 est réalisé en silicium monocristallin.

Ici, le guide d'onde 76 et le composant optique 72 sont enterrés à l'intérieur d'une sous-couche 122 d'encapsulation située directement sous la sous-couche 90 d'oxyde. Plus précisément, la sous-couche 122 s'étend depuis une sous-couche 120 jusqu'à la sous-couche 90. La sous-couche 122 se décompose ici en un niveau supérieur 92 de guidage optique et en un niveau inférieur 94 d'interconnexion électrique.

Le niveau 92 comprend tous les composants optiques et parties de composants optiques réalisés sous la sous-couche 90. Le niveau 92 comprend donc ici le guide d'onde 76, le composant optique 72 et un matériau diélectrique solide dans lequel les composants optiques et parties de composants optiques sont encapsulés. Les composants optiques encapsulés dans la sous-couche 122 et, en particulier leurs parois verticales et leurs faces inférieures, sont donc directement en contact mécanique avec le matériau diélectrique solide. Aucune cavité n'est aménagée entre les parois verticales des composants optiques encapsulés et ce matériau diélectrique solide. Par exemple, ce niveau 92 est fabriqué à partir d'une sous-couche en silicium cristallin dans laquelle ont été fabriqués le guide d'onde 76 et le composant 72 avant d'être encapsulés dans le matériau diélectrique.

Le niveau 94 est dépourvu de composant optique et de partie de composant optique. Ici, le niveau 94 comporte des réseaux de métal d'interconnexion encapsulés dans un matériau diélectrique solide comme cela sera décrit plus loin. Le matériau diélectrique de la sous-couche 122 présente un indice de réfraction inférieur à l'indice de réfraction du matériau utilisé pour réaliser le guide d'onde 76 et le composant 72. Par exemple, le matériau diélectrique est le dioxyde de silicium.

Les couches 78, 80 et 82 sont quant à elles réalisées dans une sous-couche 128 située directement sur la sous-couche 90. La sous-couche 128 comporte ici un matériau III-V dans lequel sont réalisées les couches 78, 80 et 82 et un matériau diélectrique qui encapsule les couches 78, 80 et 82. La sous-couche 128 s'étend horizontalement directement au-dessus de la sous-couche 90 et sa face supérieure correspond à la face 32.

Pour alimenter et/ou transmettre des signaux électriques à travers la couche 38, cette couche 38 comporte des via, appelés « via secondaires ». Chaque via secondaire prolonge un via primaire à l'intérieur de la couche optique 38. A cet effet, chaque via secondaire s'étend depuis l'interface 40 de collage vers l'intérieur de la couche 38. Pour limiter les contraintes à respecter sur le placement des composants optiques par rapport à ces via secondaires, le diamètre des via secondaires est beaucoup plus petit que le diamètre des via primaires. Ici, le diamètre des via secondaires est inférieur à 3 µm et, de préférence, inférieur à 1 µm. Pour faciliter la réalisation de tels via secondaires, l'épaisseur de la couche 38 est inférieure à 15 µm ou ou 8 µm ou 5 µm.

Par la suite, on classe les via secondaires en deux catégories. Une première catégorie appelée « via secondaire traversant » et une seconde catégorie appelée « via secondaire non-traversant ».

Les via secondaires traversant traversent l'épaisseur de la couche 38 et donc, en particulier, le niveau 92 de guidage optique. Ils s'étendent donc verticalement depuis l'interface 40 de collage jusqu'à la face supérieure 32. Ils sont typiquement utilisés pour raccorder électriquement des pistes électriques formées sur la face supérieure 32 à l'un des via primaires. A l'inverse, les via secondaires non-traversants ne traversent pas complètement l'épaisseur de la couche 38 et, en particulier, ne traversent pas le niveau 92 de guidage optique. Ils s'étendent donc depuis l'interface 40 de collage jusqu'à un contact électrique, tel que le contact 74, enfoui à l'intérieur de la couche 38.

A titre d'illustration, la figure 2 représente deux via secondaires traversants 100 et 102. Le via 100 raccorde électriquement le via primaire 50 à une piste électrique 106 réalisée sur la face 32. Ici, la piste 106 raccorde électriquement l'extrémité supérieure du via 100 à la prise 84. L'extrémité inférieure du via 100 est directement en contact mécanique et électrique avec la ligne de métal 58.

Le via secondaire traversant 102 raccorde électriquement le via primaire 51 à une piste électrique 108 réalisée sur la face 32. La piste 108 raccorde électriquement l'extrémité du via 102 à la prise 86. L'extrémité inférieure du via 102 est directement en contact mécanique et électrique avec la ligne de métal du via 51. Ici, les via 100 et 102 sont utilisés pour alimenter le composant 70.

La structure du via 102 est identique à celle du via 100. Ainsi, seule la structure du via 100 est décrite ci-dessous plus en détail.

Dans ce mode de réalisation, le via 100 comporte une partie inférieure 110 et une partie supérieure 112 disposées immédiatement l'une au-dessus de l'autre. Les parties 110 et 112 sont réalisées, lors de la fabrication, à partir de côtés opposés de la couche optique.

La partie inférieure 110 est un réseau de métal d'interconnexion. Ici, cette partie 110 comporte :
- une ligne de métal 114 enfouie à l'intérieur du niveau 94 de la sous-couche 122 ,
- une ligne de métal 116 qui affleure l'interface 40 de collage, et
- des via métalliques 118 qui s'étendent verticalement directement depuis la ligne de métal 116 jusqu'à la ligne de métal 114.

Le diamètre de la partie inférieure 110 est défini de la même manière que pour la partie supérieure 58 du via primaire 50. Le diamètre de la partie 110 est inférieur à 3 µm ou à 1 µm.

Dans ce mode de réalisation, le réseau de métal d'interconnexion qui forme la partie 110 comporte seulement deux niveaux de lignes de métal. Par exemple, il s'agit des niveaux souvent désignés par les références M4 et M5.

Généralement, la hauteur de cette partie 110 est faible, c'est-à-dire inférieure à 6 µm ou 3 µm ou 1µm.

Ici, la ligne de métal 116 est réalisée dans une sous-couche d'oxyde de silicium 120 dont la face inférieure est confondue avec l'interface 40 de collage. La sous-couche 120 est directement réalisée sous la sous-couche 122. Ici, la sous-couche 120 est réalisée en dioxyde de silicium.

Les via métalliques 118 sont situés à l'intérieur du niveau 94 de la sous-couche 122.

La partie supérieure 112 du via secondaire 100 est formée d'un revêtement 124 en matériau conducteur. Par exemple, le revêtement 124 est réalisé en cuivre ou en aluminium. Ce revêtement 124 recouvre continûment les parois verticales et le fond d'un trou 126 creusé dans la couche 38. Plus précisément, le trou 126 s'étend depuis la face supérieure 32 jusqu'à la ligne de métal 114. Pour cela, le trou 126 traverse successivement en allant du haut vers le bas, la couche 128 d'encapsulation, la sous-couche 90, le niveau 92 de guidage optique et une partie du niveau 94 de la sous-couche 122.

Le diamètre maximal du trou 126 est inférieur à 3 µm et, de préférence, inférieur à 1 µm. Ainsi, le diamètre maximal de la partie supérieure 112 du via secondaire 100 est également inférieur à 3 µm ou 1 µm.

Dans sa partie supérieure, le revêtement 124 est directement en contact mécanique et électrique avec la piste 106 et, dans sa partie inférieure, directement en contact mécanique et électrique avec la ligne de métal 114. Dans l'exemple de la figure 2, le revêtement 124 ne remplit pas la totalité du trou 126. Le centre du trou 126 est donc évidé. Pour cela, par exemple, l'épaisseur du revêtement 124 est inférieure à 500 nm ou 300 nm. Le centre du trou 126 est rempli d'un matériau électriquement non-conducteur et passivant. Avantageusement, le coefficient de dilatation de ce matériau électriquement non-conducteur est inférieur à 0,8C₁₂₄. et de préférence inférieur à 0,5C₁₂₄ ou 0,3C₁₂₄, où C₁₂₄ est le coefficient de dilatation thermique du revêtement 124. Ici, le centre du trou 126 est rempli par le même matériau diélectrique que celui de la sous-couche 122, c'est-à-dire du dioxyde de silicium.

La couche 38 comporte également un via secondaire non-traversant 130. Le via 130 raccorde électriquement le contact électrique 74 à l'extrémité supérieure du via primaire 52 pour recevoir le signal électrique de commande du composant optique 72. A cet effet, le via 130 s'étend verticalement depuis l'interface 40 de collage jusqu'au contact électrique 74. Il traverse donc complètement la sous-couche 120 et le niveau 94 de la sous-couche 122. Par contre, il ne traverse pas le niveau 92 de guidage optique ni la sous-couche 90. Le via 130 ne débouche pas dans la face supérieure 32 contrairement à un via secondaire traversant.

Le via 130 est uniquement fabriqué à partir du côté de la couche 38 tourné vers l'interface 40 de collage. Ici, le via 130 est formé par un réseau de métal d'interconnexion. Dans ce mode de réalisation, le via 130 comporte en allant du haut vers le bas :
- quatre lignes de métal enfouies 132 à 135,
- des via métalliques 140 reliant électriquement entre eux les niveaux successifs de lignes de métal, et
- une ligne de métal 138 affleurant l'interface 40 de collage et située dans la sous-couche 120.

La ligne de métal 138 est directement en contact mécanique et électrique sur l'extrémité supérieure du via primaire 52. Ici, le réseau de métal d'interconnexion comporte cinq niveaux différents de lignes de métal. Par exemple, ces cinq niveaux de lignes de métal sont souvent désignés par les références, respectivement, M1 à M5. Le diamètre du via 130 est également inférieur à 3 µm ou 1 µm.

Le guide d'onde 76 de la source laser 70 comporte au moins un contact électrique thermiquement couplé à l'une des excroissances 144A, 144B ou à la nervure 142. Ici, un contact électrique est dit "thermiquement couplé" uniquement si :
- ce contact électrique est situé dessous l'excroissance 144A ou 144B ou dessous la nervure 142, et
- séparé de l'excroissance 144A, 144B ou de la nervure 142 par une distance verticale dᵥ, la plus courte, de moins de 500 nm et, de préférence, de moins de 300 nm.

Lorsque la distance dᵥ est non nulle, le contact électrique est isolé mécaniquement de l'excroissance 144A, 144B ou de la nervure 142 par un fin film du matériau diélectrique de la sous-couche 122. L'épaisseur minimale de ce film est égale à la distance dᵥ.

Dans le mode de réalisation représenté sur les figures 2 et 3, le guide d'onde 76 comporte trois contacts électriques 148A, 148B et 148C (Figure 3). Ici les contacts 148A, 148B sont formés par les extrémités supérieures de via métalliques 140 directement en appui mécanique sur les faces inférieures, respectivement, des excroissances 144A et 144B. Ainsi, la distance dᵥ entre les contacts 148A, 148B et, respectivement, les excroissances 144A et 144B est nulle dans ce mode de réalisation. Le contact 148C est formé ici par une ligne de métal située sous la nervure 142 et séparée de la face inférieure de la nervure 142 par une distance dᵥ non nulle. De préférence, dans ce cas, pour limiter efficacement les pertes optiques, la distance dᵥ est choisie supérieure à 10 nm ou 50 nm. Par exemple, le contact 148C est formé dans le niveau M1 de lignes de métal.

Chaque contact électrique 148A, 148B et 148C est raccordé thermiquement à la couche 36 d'interconnexion par l'intermédiaire de via non-traversants, respectivement, 158A, 158B et 158C. Les via 158A, 158B et 158C sont chacun structurellement identiques, par exemple, au via 130. Toutefois, contrairement au via 130, les via 158A, 158B et 158C n'ont pas nécessairement pour fonction de raccorder électriquement les contacts 148A, 148B et 148C à un via primaire de la couche 36. Ici, l'extrémité inférieure de chaque via 158A, 158B et 158C est directement en contact mécanique et électrique avec une ligne de métal, située à l'intérieur de la sous-couche 44, qui affleure l'interface 40. Cette ligne de métal est ici électriquement isolée de tous les via primaires. Les via 158A, 158B et 158C sont ici réalisés dans un matériau qui est un bon conducteur thermique. Un matériau « bon conducteur thermique » est typiquement un matériau dont la conductivité thermique est supérieure à 1,2C₁₂₂, et de préférence supérieure à 2C₁₂₂ ou 3C₁₂₂, où C122 est la conductivité thermique du matériau diélectrique de la sous-couche 122. Ici, le matériau utilisé pour réaliser les via 158A, 158B et 158C est le même que celui utilisé pour réaliser le via 130, c'est-à-dire un métal.

Les couches 78 et 80 de la source laser 70 sont thermiquement raccordées aux via primaires 50 et 51 par l'intermédiaire, respectivement, des via secondaires 100 et 102. Ainsi, la chaleur produite par la source laser 70 est dissipée, en partie, vers la couche 36 par l'intermédiaire des via secondaires 100 et 102. La présence des via 158A, 158B et 158C améliore la dissipation thermique de la chaleur produite par la source laser 70. En effet, il est connu de l'homme de l'art que le guide d'onde 76 voit sa température augmenter lors du fonctionnement de la source laser 70. En absence des via 158A, 158B et 158C, la présence du matériau diélectrique de la sous-couche 122 sous le guide d'onde 76 ne permet pas d'évacuer efficacement la chaleur produite. Les via 158A, 158B et 158C réalisent chacun un pont thermique, ici en métal, au travers de la sous-couche 122 qui raccorde thermiquement le guide d'onde 76 à la couche 36. Cela permet d'évacuer plus efficacement la chaleur produite par la source laser 70.

Des lignes 150 de redistribution, connues sous l'acronyme RDL (« ReDistribution Lines ») sont réalisées sur la face inférieure 34 pour raccorder électriquement les extrémités inférieures des via primaires à des microbilles de soudure correspondantes. A cet effet, les lignes de redistribution comportent des plots de raccordement sur lesquels sont directement fixées les microbilles de soudure. Sur la figure 1, seules trois microbilles de soudure 152 à 154 sont représentées. Ces microbilles 152 à 154 sont destinées à être soudées sur des plots correspondants de la face supérieure du support 14 et font donc partie du réseau 22 de microbilles de soudure. Ici, les lignes 150 sont enfouies à l'intérieur d'une couche 156 d'encapsulation réalisée dans un matériau électriquement non-conducteur tel qu'un polymère.

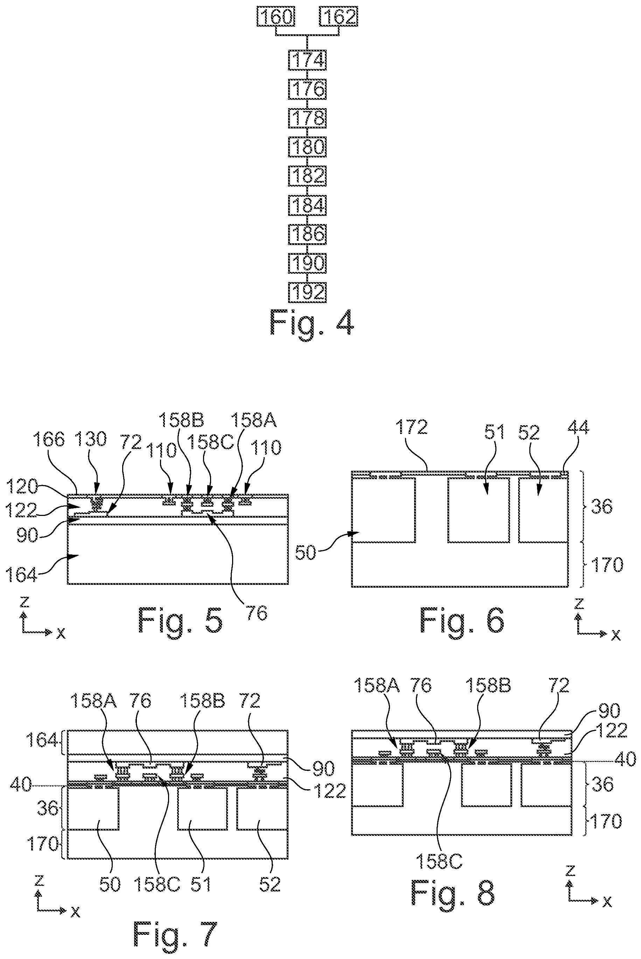

Un procédé de fabrication du système 2 va maintenant être décrit en référence à la figure 4 et aux différents états de fabrication représentés sur les figures 5 à 11.

Initialement, lors d'une étape 160, l'empilement des sous-couches 90, 122 et 120 est fabriquée sur une poignée 164 (figure 5) puis fournie. Ici, cet empilement constitue une partie seulement de la couche optique 38 car il manque, à ce stade, notamment, la couche 128. A ce stade, la sous-couche 120 est située du côté opposé à la poignée 164 et présente une face 166 de collage. Cette face 166 est apte à être collée sur un autre substrat par collage direct, c'est-à-dire par un collage qui ne nécessite pas d'apport de matière.

L'étape 160 comporte également :
- la réalisation du guide d'onde 76 et du composant optique 72 à l'intérieur du niveau 92 de la sous-couche 122,
- la réalisation du via secondaire 130 et des via 158A, 158B et 158C, et
- la réalisation des parties inférieures 110 des via secondaires 100 et 102.

La sous-couche 90 est directement fixée sur la poignée 164. La poignée 164 est un support qui permet de manipuler aisément l'empilement des sous-couche 120, 122 et 90. A cet effet, l'épaisseur de la poignée 164 est typiquement supérieure à 250 µm ou 500 µm. Par exemple, ici, la poignée 164 est un substrat en silicium d'épaisseur 750 µm ou 775 µm.

De préférence, la sous-couche 90 est la couche d'oxyde enfouie d'un substrat connu sous l'acronyme SOI (« Silicon On Insulator »). Dans ce cas, le guide d'onde 76 et le composant 72 sont réalisés, typiquement par gravure, dans la couche de silicium monocristallin de ce substrat SOI. Une fois que le guide d'onde 76 et le composant optique 72 ont été réalisés sur la sous-couche 90, ceux-ci sont enterrés dans le matériau diélectrique de la sous-couche 122 en déposant successivement plusieurs couches d'oxyde les unes après les autres. Lors des dépôts de ces couches d'oxyde successives, les réseaux de métal d'interconnexion formant les contacts 148A, 148B, 148C, le via secondaire 130, les via 158A, 158B et 158C et les parties inférieures 110 des via secondaires 100 et 102 sont réalisés. Ainsi, ces réseaux de métal d'interconnexion sont réalisés à partir du côté opposé à la poignée 164. Les méthodes de réalisation des composants optiques sur la sous-couche 90, les méthodes d'enfouissement de composants à l'intérieur de la sous-couche 122 et les méthodes de réalisation de réseaux de métal d'interconnexion sont bien connues et ne sont donc pas décrites ici plus en détail. On notera qu'à ce stade du procédé de fabrication, la réalisation des parties supérieures 112 des via secondaires 100 et 102 est impossible. La sous-couche 122 ne comporte donc pas, à ce stade, les parties supérieures 112 des via 100 et 102.

En parallèle, lors d'une étape 162, la couche 36 d'interconnexion est fabriquée sur une poignée 170 (figure 6) puis fournie. Dans cet état, la couche 36 présente une face extérieure 172 située du côté opposé à la poignée 170. Cette face 172 est une face de collage, c'est-à-dire apte à être collée, par collage direct, sur la face 166. L'épaisseur de la poignée 170 est supérieure à 250 µm ou 500 µm pour permettre une manipulation aisée de la couche 36. Ici, la poignée 170 est par exemple un substrat en silicium.

L'étape 162 comporte également la réalisation des via primaires 50 à 52 dans la couche 36. Ainsi, à l'issue de l'étape 162, la couche 36 comporte ces via primaires 50 à 52. La réalisation d'une telle couche 36 sur la poignée 170 et la réalisation des via 50 à 52 dans cette couche 36 sont conventionnels. Par exemple, les parties 54 des via 50 à 52 sont constitués d'un revêtement en matériau diélectrique, recouvert d'une couche barrière de Titane ou de Tantale, et rempli de cuivre. Un procédé de fabrication de ces parties 54 est par exemple décrit dans l'article de Ken Miyairi précédemment cité. Ensuite, les via métalliques 60 sont réalisés, en contact électrique avec les parties 54 des via primaires. Enfin, les lignes de métal telles que la ligne de métal 58, sont réalisées puis encapsulées dans la sous-couche 44 d'oxyde. La face extérieure de la sous-couche 44 est alors préparée pour son collage direct sur la face 166.

Lors d'une étape 174, les faces 166 et 172 sont collées, par collage direct, l'une sur l'autre. Ceci est représenté sur la figure 7. L'interface de collage 40 est alors obtenue. Par exemple, il s'agit d'un collage direct hybride cuivre-oxyde tel que décrit dans l'article suivant : Yan Beillard et Al : « Chip to wafer copper direct bonding electrical characterization and thermal cycling », 3D Systems Integration Conférence (3DIC), 2013 IEEE International.

Ensuite, lors d'une étape 176, la poignée 164 est retirée pour mettre à nu la sous-couche 90 (figure 8). Par exemple, la poignée 164 est retirée par polissage mécanique et chimique connu sous l'acronyme CMP (« Chemical Mechanical Polishing »), puis par gravure chimique sélective.

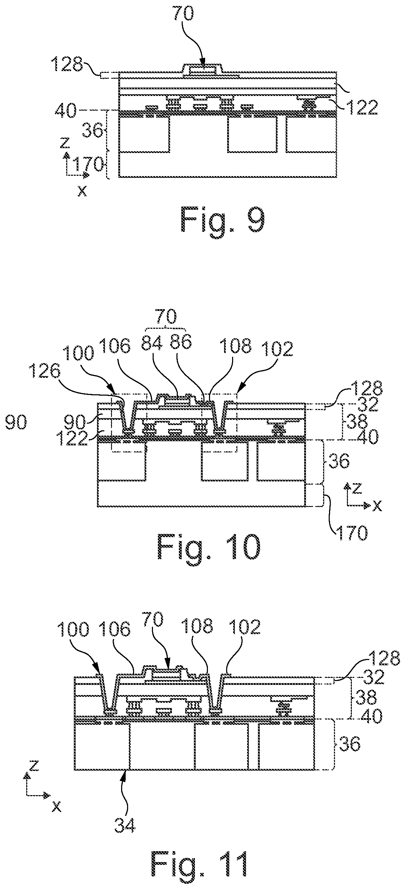

Lors d'une étape 178, la partie amplificatrice de lumière du composant 70 est réalisée sur la sous-couche 90, du côté opposé au niveau 92 de guidage optique (figure 9) et encapsulée dans le matériau diélectrique de la couche 128 d'encapsulation.

Lors d'une étape 180, les prises 84, 86, les pistes électriques 106 et 108 et les parties supérieures 112 des via secondaires 100 et 102 sont réalisées (figure 10). Par exemple, des trous tels que le trou 126 sont d'abord creusés à travers les sous-couches 128, 90 et du niveau 92 de la sous-couche 122. Ensuite, un revêtement en matériau conducteur est déposé sur toute la face extérieure. Enfin, ce revêtement conducteur est gravé pour ne laisser subsister le revêtement conducteur qu'aux emplacements des prises 84, 86, des pistes 106 et 108 et des parties supérieures 112 des via secondaires 100 et 102. La réalisation de la couche 38 est alors terminée.

Lors d'une étape 182, la poignée 170 est alors retirée à son tour pour mettre à nu la face inférieure 34 (figure 116).

Lors d'une étape 184, les lignes de redistribution 150, les microbilles de soudure 152 à 154 et la couche 156 d'encapsulation sont réalisées sur la face inférieure 34 mise à nu. La fabrication de la puce photonique 18 est alors terminée.

Lors d'une étape 186, la puce électronique 16 et la puce photonique 18 sont soudées sur des plots de la face supérieure du support 14. Les puces 16 et 18 sont alors connectées électriquement l'une à l'autre par l'intermédiaire des connexions horizontales du support 14.

Lors d'une étape 190, le support 14 et les puces 16 et 18 sont encapsulés dans un matériau électriquement non-conducteur et bon conducteur thermique tel qu'une résine epoxy. De plus, de préférence, un capot sur lequel est disposé un dissipateur thermique, tel qu'un radiateur, est fixés sur les faces supérieures des puces 16 et 18. Ce capot est par exemple collé, à l'aide d'une colle thermiquement conductrice, directement sur la face supérieure 32 de la puce photonique 18 et la face supérieure de la puce 16. Ainsi, ces faces supérieures peuvent être directement en contact avec la colle thermique qui est en contact avec le capot. Ceci est rendu possible par le fait que tous les signaux électriques et les alimentations électriques sont amenés par les faces inférieures des puces 16 et 18.

Ensuite, lors d'une étape 192, le système 2 est par exemple soudé sur le circuit imprimé 4.

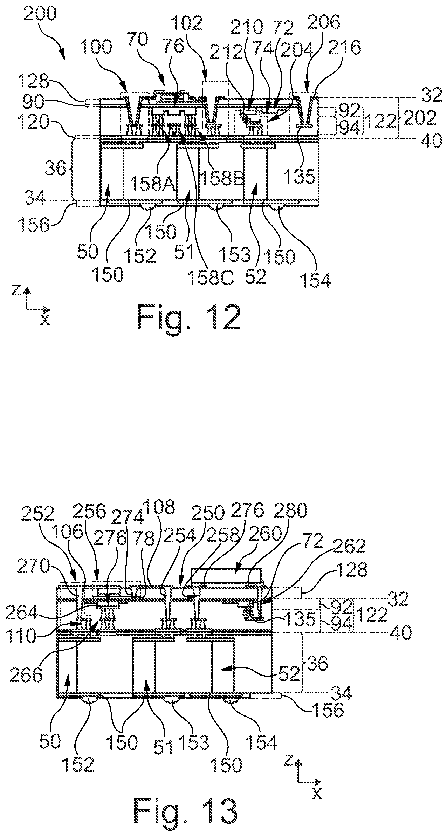

La figure 12 représente une puce photonique 200 qui peut être utilisée à la place de la puce photonique 18 dans le système 2. La puce 200 est identique à la puce 18 sauf que :
- la couche optique 38 est remplacée par une couche optique 202,
- le via secondaire 130 est remplacé par un via secondaire non-traversant 204, et
- la puce photonique 200 comporte un via tertiaire 206.

La couche optique 202 est identique à la couche optique 38 sauf qu'elle comporte en plus un composant électronique actif 210 enterré à l'intérieur du niveau 92 de la sous-couche 122. Ce composant électronique 210 est qualifié d'actif car, pour fonctionner, il a besoin d'être alimenté électriquement, et il émet et/ou reçoit un signal électrique. A cet effet, le composant 210 comporte un contact électrique 212 sur sa face inférieure. Ce contact électrique 212 est donc enfoui à l'intérieur de la sous-couche 122 et tourné vers l'interface 40 de collage.

Ici, le via secondaire 204 raccorde électriquement le contact électrique 212 du composant électronique 210 au via primaire 52 en traversant seulement le niveau inférieur 94 de la sous-couche 122 et la sous-couche 120. Le composant électronique 210 est, par exemple, destiné à fournir, à partir d'un signal électrique qu'il reçoit par le via primaire 52, un signal électrique de commande au composant optique 72. A cet effet, le composant 210 comporte sur sa face inférieure un autre contact électrique raccordé au contact 74 du composant 72. Pour cela, le réseau de métal d'interconnexion situé à l'intérieur du niveau 94 de la sous-couche 122 est modifié pour créé un chemin qui raccorde électriquement ensemble cet autre contact électrique et le contact 74. Pour simplifier la figure 12, cette modification du réseau de métal d'interconnexion n'a pas été représentée sur la figure 12. La structure et la fabrication du via 204 se déduisent des explications données pour le via 130.

Le via 206 est un via qui raccorde électriquement une ligne de métal 135, enfouie à l'intérieur du niveau 94 de la sous-couche 122, à une piste électrique 216 réalisée sur la face supérieure 32. Le via 206 s'étend verticalement depuis la face 32 jusqu'à la ligne 135 de métal enfouie en traversant notamment la sous-couche 90 et le niveau 92 de guidage optique.

La piste électrique 216 comporte un plot de test qui permet de tester le bon fonctionnement des composants 210 et/ou 72 au cours du procédé de fabrication de la puce photonique 200 et, en particulier, avant le retrait de la poignée 170. A cet effet, mais non représenté sur la figure 12, le réseau de métal d'interconnexion, situé à l'intérieur du niveau 94 de la sous-couche 122, est également modifié pour créer, à l'aide des lignes de métal et des via métalliques, un chemin électrique qui raccorde électriquement les contacts électriques 212 et/ou 74 à la ligne de métal 135.

La structure du via 206 est ici identique à celle du via 100 sauf qu'il est dépourvu de partie inférieure 110. Typiquement, le via 206 est fabriqué de la même manière que la partie supérieure 112 du via 100 et généralement en même temps que cette partie supérieure 112.

La figure 13 représente une puce photonique 250 susceptible d'être utilisée à la place de la puce photonique 18 dans le système 2. La puce photonique 250 est identique à la puce photonique 18 sauf que :
- les via secondaires traversants 100 et 102 sont remplacés par des via secondaires traversants, respectivement, 252 et 254,
- le composant 70 est remplacé par une source laser 256,
- le via secondaire 130 est remplacé par un via secondaire traversant 258, une puce électronique 260 et un via tertiaire 262.

Les via secondaires traversants 252 et 254 sont identiques, respectivement, aux via 100 et 102 sauf que leur partie supérieure 270 est réalisée différemment. Plus précisément, la partie supérieure 270 est ici un via plein. Autrement dit, la partie supérieure 270 est identique à la partie supérieure 112, sauf que l'évidement central du trou 126 est rempli d'un matériau conducteur. Généralement, dans ce cas, le diamètre maximal de la partie supérieure 270 des via 252 et 254 est inférieur à 1 µm.

La source laser 256 est identique au composant 70, sauf que :
- la prise 86 est remplacée par une prise 274, et
- le guide d'onde 76 est remplacé par une guide d'onde 276

La prise 274 est un via métallique qui raccorde électriquement la couche 78 à la piste électrique 108.

Le guide d'onde 276 est identique au guide d'onde 76 sauf que les excroissances 144A et 144B sont omises. De même, les contacts 148A, 148B et les via 158A et 158B sont omis. De plus, l'épaisseur de la nervure centrale 142 est alors choisie pour que le signal optique guidé par la source laser 256 soit principalement situé à l'intérieur de la couche 80. Par exemple, à cet effet, l'épaisseur e₁₄₂ est inférieure à 300 nm ou 200 nm. Enfin, dans ce mode de réalisation, le contact 148C est remplacé par un contact 264 pour lequel la distance dᵥ entre ce contact 264 et la face inférieure de la nervure 142 est nulle. Le via 158C est remplacé par un via 266 dont la structure est, par exemple, identique au via 158A ou 158B précédemment décrit.

Le via secondaire traversant 258 raccorde électriquement et directement le via primaire 52 à une piste électrique 276 réalisée sur la face supérieure 32. La piste 276 comporte un plot sur lequel est soudé un premier contact électrique de la puce électronique 260. La structure du via 258 est ici identique à celle du via 252.

Le via 262 raccorde électriquement directement une piste électrique 280 réalisée sur la face supérieure 32 à la ligne de métal 135 enfouie à l'intérieur du niveau 94 de la sous-couche 122. A cet effet, par exemple, la structure du via 262 est identique à la structure du via 252 sauf que la partie inférieure 110 est omise. La piste électrique 280 comporte un plot sur lequel est soudé un second contact électrique de la puce électronique 260.

Ici, la ligne de métal 135 est électriquement raccordée au contact électrique 74 du composant optique 72 par l'intermédiaire d'un réseau de métal d'interconnexion similaire à celui décrit en référence à la figure 12. Typiquement, la puce électronique 260 est un transducteur, alimenté électriquement par des via primaires, qui commande le composant optique 72 en fonction de signaux électriques reçus par l'intermédiaire du via primaire, par exemple, 52.

### Chapitre II : Variantes :

### Chapitre II.1 : Variantes des via :

La section transversale horizontale d'un via n'est pas nécessairement circulaire. Par exemple, la section transversale d'un via peut être carrée ou rectangulaire. Dans ce cas, par « diamètre », on désigne le diamètre hydraulique de cette section transversale horizontale.

Comme illustré dans le cas du via secondaire dans les précédents modes de réalisation, le diamètre du via n'est pas nécessairement constant sur toute sa hauteur. Dans ce cas, par « diamètre » du via, on désigne le plus grand diamètre de ce via le long de sa hauteur.

En variante, la partie supérieure 56 du via primaire est omise. Dans ce cas, l'extrémité supérieure de la partie 54 du via primaire affleure directement l'interface 40 de collage.

Dans une autre variante, les via métalliques 60 sont omis. Dans ce cas, l'extrémité supérieure de la partie 54 est directement en contact mécanique et électrique avec la ligne de métal 58.

Dans un autre mode de réalisation, la partie supérieure 56 d'un via primaire peut comporter plusieurs lignes supplémentaires de métal réalisées à des profondeurs différentes à l'intérieur de la sous-couche 44. Les différents niveaux de lignes de métal de la partie 56 sont alors électriquement raccordés entre eux par des via métalliques. Ces lignes supplémentaires de métal forment alors une couche de redistribution ou RDL qui permet, par exemple, de raccorder électriquement entre elles plusieurs lignes de métal qui affleurent l'interface 40.

Le réseau de métal d'interconnexion utilisé pour former la partie inférieure d'un via secondaire traversant peut aussi, en variante, comporter plus de trois niveaux de lignes de métal.

En variante, la partie inférieure 110 d'un via secondaire traversant est omise. Dans ce cas, le fond du trou 126 débouche alors directement sur la ligne de métal 58 du via primaire. Un tel via secondaire traversant ne comporte alors qu'une seule partie, à savoir la partie 112.

Le centre du trou 126 peut aussi être rempli avec un matériau diélectrique différent du matériau diélectrique de la sous-couche 122. Par exemple, il est rempli d'un matériau organique.

Dans un autre mode de réalisation, la partie supérieure 112 d'un via secondaire est réalisée à l'aide d'un ou plusieurs via métalliques qui s'étendent chacun depuis la face 32 jusqu'à la ligne 114 de métal.

S'il n'est pas nécessaire de relâcher les contraintes à respecter sur le placement des composants optiques par rapport aux via secondaires, le diamètre des via secondaires peut être supérieur à 3 µm et, en particulier, égal ou supérieur au diamètre des via primaires.

En variante, la distance dᵥ entre les contacts 148A, 148B et les excroissances 144A, 144B est non nulle. Dans ce cas, la distance dᵥ est par exemple choisie comme décrit dans le cas du contact 148C.

Dans un mode de réalisation particulier, le via 148C est omis. Dans ce cas, la chaleur du guide d'onde 76 se dissipe uniquement par l'intermédiaire des via 158A et 158B.

### Chapitre II.2 : Autres variantes de la structure de la puce photonique :

En variante, la couche 36 d'interconnexion peut être réalisée dans d'autres matériaux que du silicium. Par exemple, elle est réalisée en verre.

Dans une autre variante, la couche 36 comporte un ou plusieurs composants électroniques.

Les sous-couches de la couche optique 38 peuvent aussi être réalisées dans d'autres matériaux. En particulier, la sous-couche 122 peut être réalisée à l'aide d'un autre matériau diélectrique comme par exemple du silicium amorphe, du nitrure de silicium SiN ou d'oxyde de nitrure de silicium SiON.

Les différentes sous-couches d'oxyde de la couche 38 ne sont pas nécessairement toutes réalisées dans le même oxyde. En variante, la sous-couche 120 est réalisée dans un oxyde différent de celui utilisé pour réaliser la sous-couche 90. Il est aussi possible d'utiliser un oxyde pour réaliser la sous-couche 122 qui est différent de celui de la sous-couche 90.

La couche optique peut en plus être traversée par des via supplémentaires dont le diamètre est supérieur à 3 µm et, par exemple, supérieur à 10 µm ou 20 µm. Dans ce cas, une zone d'exclusion de surface importante est prévue autour de chacun de ces via supplémentaires et aucun composant optique n'est réalisé à l'intérieur de cette zone d'exclusion. Cette zone d'exclusion est dimensionnée conformément à l'enseignement donné dans l'article suivant : Yan Yang et Al : « Though-Si-via (TSV), Keep-Out-Zone (KOZ) in SOI photonics interposer : A study of impact of TSV-Induced stress on Si ring resonators », IEEE Photonics Journal, volume 5, Number 6, December 2013. Par la suite, cet article est désigné par la référence « Yang2013 ». Toutefois, même si la puce photonique comporte quelques-uns de ces via supplémentaires, l'implantation des composants optiques dans la couche optique est quand même simplifiée à cause de la présence de via secondaires qui limite quand même les contraintes sur le placement des composants optiques.

Le nombre de composants optiques enterrés à l'intérieur du niveau 92 de la sous-couche 122 peut être quelconque. De plus, les différents composants optiques ne sont pas nécessairement enterrés à l'intérieur du niveau 92 à la même profondeur. C'est notamment le cas si les composants optiques ou parties de composants optiques sont fabriqués à partir de différentes sous-couches de matériau empilées les unes sur les autres. Ces sous-couches de matériau peuvent alors être choisies dans le groupe constitué d'une sous-couche de silicium cristallin, d'une sous-couche de silicium amorphe, d'une sous-couche de nitrure de silicium SiN et d'une sous-couche d'oxyde de nitrure de silicium SiON.

En variante, l'extrémité inférieure d'un ou plusieurs des via 158A, 158B, 158C et 266 est électriquement et mécaniquement raccordée à au moins un via primaire pour améliorer la dissipation thermique de la chaleur produite par la source laser. Ainsi, dans un premier mode de réalisation, l'extrémité inférieure d'au moins un des via 158A, 158B et 266 est électriquement et mécaniquement raccordée à un via primaire utilisé pour connecter électriquement l'un des composants de la puce 18 au support 14. Par exemple :
- les extrémités inférieures des via 158A et 158B sont électriquement et mécaniquement raccordées respectivement, aux via primaires 50 et 51, ou
- les extrémités inférieures des via 158A et 158B sont électriquement et mécaniquement raccordées toutes les deux au via primaire 50 ou 51 ou 52, ou
- l'extrémité inférieure du via 266 est électriquement et mécaniquement raccordée au via primaire 50 ou 51 ou 52.
Dans un second mode de réalisation, l'extrémité inférieure d'au moins un des via 158A, 158B et 266 est électriquement et mécaniquement raccordée à un via primaire supplémentaire. Ce via primaire supplémentaire est électriquement isolé. Il est donc isolé électriquement des via primaires 50, 51 et 52. Ce via primaire supplémentaire n'est donc pas utilisé pour établir une connexion électrique. Par exemple, l'extrémité inférieure du via 158A ou 158B est électriquement et mécaniquement raccordée à un tel via primaire supplémentaire

Le diamètre d'un ou plusieurs des via 158A, 158B, 158C et du via 266 n'est pas nécessairement inférieur à 3 µm ou 1 µm. Son diamètre peut aussi être supérieur à ces valeurs.

L'utilisation des via 158A, 158B, 158C et 266 pour améliorer la dissipation de la chaleur produite par une source laser s'applique de façon similaire à l'amélioration de la dissipation de la chaleur produite par tout type de composant optique ou électronique dont au moins une partie est enfouie à l'intérieur de la sous-couche 122. Par exemple, un via similaire au via 158C ou 266 peut aussi être utilisé pour dissiper la chaleur produite par le composant optique 72 ou le composant électronique 210.

D'autres modes de réalisation du guide d'onde 76 sont possibles. Par exemple, en variante, l'excroissance 144B et le rebord 146B sont omis. Dans ce cas, le contact 148B et le via 158B sont également omis. L'épaisseur des excroissances 144A, 144B peut être supérieure à l'épaisseur e₁₄₂ de la nervure 142. Dans une autre variante, seules les excroissances 148A et 148B sont omises et les rebords 146A et 146B sont conservés. Dans ce dernier cas, les contacts 148A et 148B peuvent être formés sous, respectivement, les rebords 146A et 146B de la même manière que ce qui a été décrit dans le cas où ils sont formés sous les excroissances 148A, 148B.

### Chapitre II.3 : Autres variantes :

La puce photonique peut comporter une piste électrique réalisée sur la face supérieure 32 qui n'est pas nécessairement utilisée pour raccorder électriquement un composant optique à l'un des via primaires. Par exemple, comme décrit dans le mode de réalisation de la figure 13, une telle piste électrique 276 peut être uniquement utilisée pour raccorder électriquement une puce électronique soudée sur la face supérieure 32 de la puce photonique à l'un des via primaires.

Dans un mode de réalisation, la puce photonique comporte seulement des via secondaires non-traversants. Dans ce cas, tous les via secondaires non-traversants sont fabriqués à partir du côté opposé à la poignée 164. L'ordre de retrait des poignées peut alors être inversé. Ainsi, la poignée 170 peut être retirée avant la poignée 164. En effet, il n'est pas nécessaire de fabriquer la partie supérieure 112 de via secondaires traversants. Dans ce cas également, le via secondaire non-traversant est entièrement fabriqué avant le collage de la couche 38 sur la couche 36.

Dans un autre mode de réalisation, la puce photonique comporte seulement des via secondaires traversants.

Alternativement la puce 260 peut correspondre à la puce 16 de la figure 1. Dans ce cas la puce électronique 260 est un ASIC alimenté électriquement par l'intermédiaire des via primaires, et qui commande le composant optique 72 avec des signaux électriques qu'il génère.

D'autres procédés de fabrication sont également possibles.

Le fait de connecter thermiquement une partie du composant 70 ou de la source laser 256 à la couche d'interconnexion par l'intermédiaire de via secondaires, typiquement non-traversant, comme les via 158A, 158B, 158C et 266, peut être mis en œuvre indépendamment des autres caractéristiques décrites ici de la puce photonique. En particulier, cela peut être mis en œuvre dans un contexte où les via primaires traversent la couche optique comme décrit dans l'article Yang2013 ou dans un contexte où tous les via primaires sont omis. Lorsque les via primaires sont omis, la couche 36 n'est plus une couche d'interconnexion mais simplement un support pour la couche optique 38. Lorsque les via primaires sont omis, de préférence, l'épaisseur de la sous-couche superficielle 44 est suffisamment fine pour ne pas isoler thermiquement les via secondaires de la sous-couche 42. Par exemple, dans ce cas, la sous-couche superficielle 44 est omise ou son épaisseur est inférieure à 100 nm ou 50 nm. Si l'épaisseur de la sous-couche superficielle 44 est importante, c'est-à-dire, supérieure à 100 nm ou 300 nm, la partie supérieure 56 peut être conservée pour former un pont thermique qui traverse la sous-couche 44 et seule la partie inférieure 54 des via primaires est omises. Dans ce cas, la partie supérieure 56 peut être isolée électriquement de la sous-couche 42 en silicium par une fine couche en matériau diélectrique d'épaisseur inférieure à 100 nm ou à 50 nm.

### Chapitre III : Avantages des modes de réalisation décrits :

Le fait de connecter thermiquement le guide d'onde 76 ou 276 à la couche d'interconnexion par l'intermédiaire de via dont l'extrémité inférieure est directement en contact mécanique avec la couche 36, permet d'améliorer la dissipation thermique de la chaleur produite par la source laser lors de son fonctionnement par rapport aux modes de réalisation décrits dans l'article de J.Durel et Al cité dans l'introduction de cette demande. De plus, la fabrication de la puce photonique reste particulièrement simple. En particulier, le fait que les via 158A, 158B, 158C et 266 soient formés par des réseaux de métal d'interconnexion simplifie la fabrication de ces via et donc de la puce photonique. Le fait que ces via soient uniquement situés à l'intérieur du niveau inférieur 94 d'interconnexion permet de limiter les contraintes sur la placement des composants optiques par rapport au cas où des via traversant en plus le niveau supérieur 92 de guidage optique seraient utilisés pour créer ces ponts thermiques entre le guide d'onde 76, 276 et la couche 36.

Il est connu des inventeurs que, normalement, la présence d'un contact électriquement conducteur directement en appui sur une partie d'un guide d'onde augmente les pertes optiques de ce guide d'onde. Or, une telle augmentation des pertes optiques doit être, de préférence, limitée autant que possible. Dans ce contexte, le fait de combiner dans un même mode de réalisation, une épaisseur e₁₄₂ de la nervure centrale 142 inférieure à 300 nm et une distance dᵥ nulle entre le contact 264 et la nervure centrale 142 permet d'améliorer la dissipation de la chaleur sans pour autant augmenter de façon substantielle les pertes optiques. En effet, lorsque l'épaisseur e₁₄₂ est inférieure à 300 nm, l'essentielle du signal optique guidé est confiné dans la couche active 80. Dans ce cas, le fait que le contact 264 soit directement en appui mécanique sur la nervure 142 augmente très peu les pertes optiques.

Le fait que la distance dᵥ entre le contact 148C et la face inférieure de la nervure 142 soit supérieure à 10 nm ou 50 nm permet de limiter les pertes optiques. De plus, le fait que cette distance dᵥ soit en plus inférieure à 500 nm permet d'améliorer la dissipation de la chaleur vers la couche 36.

L'utilisation d'excroissance 144A, 144B et de via 158A, 158C dont l'extrémité supérieure est directement en appui sur ces excroissances 144A, 144B permet aussi à la fois d'améliorer la dissipation de la chaleur sans pour autant augmenter de façon substantielle les pertes optiques. En effet, à cause des rebords 146A, 146B, le signal optique guidé dans les excroissances 144A, 144B est négligeable. Ainsi le fait que ces excroissances soient directement en appui sur l'extrémité supérieure des via 158A, 158B n'augmente quasiment pas les pertes optiques tout en améliorant la dissipation de la chaleur.

Il est connu que la présence de via traversants à proximité d'un composant optique pose des problèmes. En effet, de tels via sont réalisés dans un matériau électriquement conducteur, dont le coefficient de dilatation thermique est différent du matériau dans lequel est réalisé le composant optique. Ainsi, en réponse à des variations de température, les via traversant exercent sur le composant optique situé à proximité une contrainte mécanique qui varie en fonction de la température. Cette variation de la contrainte mécanique modifie les propriétés optiques du composant optique et entraîne une modification des propriétés de ce composant optique. Par exemple, lorsque le composant optique est un filtre optique, cela modifie sa longueur d'onde centrale. De telles variations des propriétés du composant optique doivent être évitées. Dans les modes de réalisation décrits, les via primaires ne génèrent pas de contrainte mécanique substantielle sur les composants optiques. En effet, la couche 36 d'interconnexion est totalement dépourvue de composant optique. Ceux-ci sont uniquement situés à l'intérieur de la couche optique. Par conséquent, les composants optiques peuvent être implantés les uns par rapport aux autres sans se soucier de la disposition des via primaires. En particulier, il n'est pas nécessaire de respecter une quelconque zone d'exclusion autour de chaque via primaire. Les via secondaires traversants le niveau 92 de guidage optique ont quant à eux un diamètre préférentiellement inférieur ou égal à 3 µm, voire à 1 µm. De tels via secondaires traversants peuvent ainsi être disposés à 4 µm voire à 2 µm des composants optiques sans générer de contraintes mécaniques sur ces derniers. Par comparaison, les via traversants décrits dans Yang2013, de diamètre supérieur à 10 µm, doivent être disposés à 40 µm des composants optiques pour ne pas les contraindre mécaniquement. Il est donc possible de placer les composants optiques beaucoup plus près des via secondaires que ce qui aurait été possible si leur diamètre avait été égal au diamètre des via primaires. La combinaison dans une même puce photonique des via primaires et des via secondaires permet donc d'obtenir une puce photonique suffisamment épaisse pour avoir une flèche acceptable tout en limitant les contraintes à respecter pour placer les composants optiques par rapport aux via. On notera également que la couche d'interconnexion ne contient pas nécessairement de couche d'oxyde de silicium enterré. Son épaisseur minimale donnant lieu à une flèche acceptable est donc moindre que celle d'une couche qui contiendrait un oxyde de silicium enterré. Avoir une épaisseur moindre de la couche d'interconnexion permet notamment de diminuer les capacités parasites des via primaires. En effet, cette capacité parasite est proportionnelle à la hauteur des via primaires.

Pour les puces 18, 200 et 250, le fait de placer la source laser sur la face supérieure de la couche d'oxyde 90 facilite son refroidissement à partir de l'extérieur, notamment grâce à la mise en boîtier du système.

Le fait que le centre du trou 126 soit rempli d'un matériau électriquement non-conducteur dont le coefficient de dilatation thermique est plus petit que celui du revêtement 124 permet de limiter encore plus les contraintes mécaniques exercées par le via secondaire sur les composants optiques situés à proximité.

## Revendications

1. Puce photonique s'étendant essentiellement dans un plan appelé « plan de la puce », cette puce photonique comportant :
- un substrat (30) présentant des faces supérieure (32) et inférieure (34) parallèles au plan de la puce, ce substrat comportant, entre les faces supérieure et inférieure :
• un support (36) d'épaisseur supérieure à 50 µm, ce support étant dépourvu de composant optique,
• une couche optique (38 ; 202) collée, au niveau d'une interface (40) de collage, sur le support (36), cette couche optique comportant successivement, en allant de la face supérieure vers l'interface de collage (40) :
- une sous-couche (90) d'oxyde, et
- une sous-couche (122) d'encapsulation,
• une source laser (70 ; 256) enterrée à l'intérieur de la couche optique (38 ; 202), cette source laser comportant un guide d'onde (76; 276) réalisé sur le côté de la sous-couche (90) d'oxyde tourné vers l'interface (40) de collage et encapsulé dans un matériau diélectrique de la sous-couche d'encapsulation, ce guide d'onde comportant un premier contact électrique (148A, 148B, 148C; 264) enfoui à l'intérieur de la sous-couche (122) d'encapsulation,
**caractérisé en ce que** la puce photonique comporte un réseau de métal d'interconnexion formant un via (158A, 158B, 158C; 266) qui s'étend, à l'intérieur de la couche optique (38; 202), depuis l'interface (40) de collage jusqu'au premier contact électrique enfoui (148A, 148B, 148C; 264) du guide d'onde, ce réseau de métal d'interconnexion comportant des via métalliques (140) qui raccordent électriquement entre-elles des lignes de métal qui s'étendent principalement parallèlement au plan de la puce, ces lignes de métal étant disposées les une au-dessus des autres à l'intérieur de la couche optique (38 ; 202).

2. Puce photonique conforme à la revendication 1, dans laquelle :
- le guide d'onde (76; 276) comporte une nervure centrale (142), et
- le premier contact électrique enfoui (148C; 264) est situé, dans une direction perpendiculaire au plan de la puce, sous une face inférieure de la nervure centrale tournée vers l'interface (40) de collage et séparé de cette face inférieure par une distance comprise entre 0 nm et 500 nm.

3. Puce photonique conforme à la revendication 2, dans laquelle :
- l'épaisseur de la nervure centrale (142) est inférieure à 300 nm, et
- le premier contact électrique (264) enfoui est directement en contact mécanique avec cette nervure centrale.

4. Puce photonique conforme à la revendication 2, dans laquelle le premier contact électrique enfoui (148C) est séparé de la face inférieure de la nervure centrale (142) par une distance comprise entre 10 nm et 500 nm.

5. Puce photonique conforme à l'une quelconque des revendications précédentes, dans laquelle :
- le guide d'onde (76) comporte une nervure centrale (142), au moins une excroissance latérale (144A, 144B) et au moins un rebord (146A, 146B) reliant l'excroissance latérale à la nervure centrale, l'épaisseur du rebord étant au moins deux fois inférieure à l'épaisseur de la nervure centrale, et
- le premier contact électrique enfoui (148A, 148B) est directement en contact mécanique sur une face inférieure de l'excroissance latérale, cette face inférieure de l'excroissance latérale étant tournée vers l'interface (40) de collage.

6. Puce photonique conforme à l'une quelconque des revendications précédentes, dans laquelle le plus grand diamètre des via métalliques (140) du réseau d'interconnexion est inférieur à 3 µm.

7. Puce photonique selon l'une quelconque des revendications précédentes, dans laquelle :
- le support (36) est une couche d'interconnexion,
- le substrat comporte une borne électrique choisie dans le groupe constitué d'un second contact électrique (74 ; 212) enfoui à l'intérieur de la couche optique (38 ; 202), ce second contact électrique enfoui étant celui d'un composant optique (72) ou d'un composant électronique (210), et d'une piste électrique (106, 108 ; 276, 280) réalisée sur la face supérieure du substrat,
- la puce photonique comporte :
• des plots de raccordement électrique réalisés sur la face inférieure (34) du substrat, chacun de ces plots étant apte à être connecté électriquement par l'intermédiaire d'une bille (152-154) de soudure à un autre support (14),
• un via primaire (50-52) s'étendant à travers la couche d'interconnexion depuis la face inférieure (34) pour raccorder électriquement l'un des plots de raccordement à la borne électrique, ce via primaire ayant un diamètre supérieur ou égal à 10 µm,
et dans laquelle :
- l'épaisseur de la couche optique (38 ; 202) est inférieure à 15 µm,
- le via primaire (50-52) s'étend à travers la couche d'interconnexion uniquement entre la face inférieure (34) et l'interface (40) de collage de sorte que le via primaire ne se prolonge pas à l'intérieur de la couche optique (38 ; 202), et
- la puce photonique comporte un via secondaire (100, 102, 130 ; 204 ; 252, 254, 258) qui prolonge le via primaire à l'intérieur de la couche optique pour raccorder électriquement le via primaire à la borne électrique, ce via secondaire s'étendant à l'intérieur de la couche optique (38 ; 202) depuis l'interface (40) de collage jusqu'à la borne électrique, le diamètre maximal de ce via secondaire étant inférieur à 3 µm.

8. Puce photonique conforme à la revendication 7, dans laquelle le via qui s'étend, à l'intérieur de la couche optique, depuis l'interface (40) de collage jusqu'au premier contact électrique enfoui (148A, 148B, 148C; 264) du guide d'onde (76; 276), est électriquement isolé de tout via primaire.

9. Puce photonique selon l'une quelconque des revendications précédentes, dans laquelle :
- le guide d'onde (76) comporte au moins l'un des éléments suivants :
• une nervure centrale (142),
• un rebord latéral (146A, 146B) mécaniquement relié à la nervure centrale, l'épaisseur du rebord latéral étant au moins deux fois inférieure à l'épaisseur de la nervure centrale, et
• une excroissance latérale (144A, 144B) reliée à la nervure centrale (142) par le rebord latéral (146A, 146B), et
- le premier contact électrique est situé, dans une direction perpendiculaire au plan de la puce, à moins de 500 nm de la nervure centrale (142) ou du rebord (146A, 146B) ou de l'excroissance latérale (144A, 144B).

10. Procédé de fabrication d'une puce photonique conforme à l'une quelconque des revendications précédentes, **caractérisé en ce que** le procédé comporte les étapes suivantes:
- la fourniture (160) d'au moins une partie de la couche optique (38 ; 202) fixée sur une première poignée (164) d'épaisseur supérieure à 250 µm, ladite au moins une partie de la couche optique (38 ; 202) comportant successivement, en s'éloignant de la première poignée :
• une sous-couche (90) d'oxyde,
• une sous-couche (122) d'encapsulation, et
• une première face de collage,
ladite au moins une partie de la couche optique (38 ; 202) comportant également :
• un guide d'onde (76 ; 276) réalisé sur le côté de la sous-couche (90) d'oxyde tourné du côté de la première interface de collage et encapsulé dans un matériau diélectrique de la sous-couche d'encapsulation, ce guide d'onde comportant un premier contact électrique enfoui à l'intérieur de la sous-couche (122) d'encapsulation,
• un réseau de métal d'interconnexion formant un via qui s'étend, à l'intérieur de la sous-couche d'encapsulation, depuis la première face de collage jusqu'au premier contact électrique enfoui du guide d'onde, ce réseau de métal d'interconnexion comportant des via métalliques (140) qui raccordent électriquement entre-elles des lignes de métal qui s'étendent principalement parallèlement au plan de la puce, ces lignes de métal étant disposées les une au-dessus des autres à l'intérieur de la sous-couche d'encapsulation,
- la fourniture (162) du support (36) d'épaisseur supérieure à 50 µm fixée sur une deuxième poignée (170) d'épaisseur supérieure à 250 µm, ce support comportant :
• une deuxième face (172) de collage du côté opposé à la deuxième poignée, et
• le support étant dépourvu de composant optique, puis
- le collage (174) de la première face de collage sur la deuxième face de collage pour obtenir l'interface (40) de collage, puis
- le retrait (176) de la première poignée pour mettre à nu la sous-couche (90) d'oxyde de ladite au moins une partie de la couche optique, puis
- la réalisation (178) d'une partie amplificatrice de la lumière d'une source laser sur cette sous-couche (90) d'oxyde mise à nue, cette source laser comportant le guide d'onde.

## Patentansprüche

1. Photonischer Chip, der sich im Wesentlichen in einer Ebene, die "Ebene des Chips" genannt wird, erstreckt, wobei dieser photonische Chip umfasst:
- ein Substrat (30), das Ober- (32) und Unterseiten (34) aufweist, die parallel zur Ebene des Chips sind, wobei dieses Substrat zwischen den Ober- und Unterseiten umfasst:
• einen Träger (36) mit einer Dicke von mehr als 50 µm, wobei dieser Träger frei von optischen Komponenten ist,
• eine optische Schicht (38; 202), die an einer Klebegrenzfläche (40) auf den Träger (36) geklebt ist, wobei diese optische Schicht von der Oberseite aus zur Klebegrenzfläche (40) hin aufeinander folgend umfasst:
- eine Oxidteilschicht (90) und
- eine Kapselungsteilschicht (122),
• eine Laserquelle (70; 256), die im Inneren der optischen Schicht (38; 202) vergraben ist, wobei diese Laserquelle einen Wellenleiter (76; 276) umfasst, der auf der Seite der Oxidteilschicht (90) ausgeführt ist, die der Klebegrenzfläche (40) zugewandt ist, und in ein dielektrisches Material der Kapselungsteilschicht gekapselt ist, wobei dieser Wellenleiter einen ersten elektrischen Kontakt (148A, 148B, 148C; 264) umfasst, der im Inneren der Kapselungsteilschicht (122) vergraben ist,
**dadurch gekennzeichnet, dass** der photonische Chip ein Verbindungsmetallgitter umfasst, das eine Durchkontaktierung (158A, 158B, 158C; 266) bildet, die sich im Inneren der optischen Schicht (38; 202) von der Klebegrenzfläche (40) aus bis zum ersten vergrabenen elektrischen Kontakt (148A, 148B, 148C; 264) des Wellenleiters erstreckt, wobei dieses Verbindungsmetallgitter metallische Durchkontaktierungen (140) umfasst, die Metallleitungen elektrisch untereinander verbinden, die sich hauptsächlich parallel zur Ebene des Chips erstrecken, wobei diese Metallleitungen im Inneren der optischen Schicht (38; 202) übereinander angeordnet sind.

2. Photonischer Chip nach Anspruch 1, bei dem:
- der Wellenleiter (76; 276) eine zentrale Rippe (142) umfasst und
- der erste vergrabene elektrische Kontakt (148C; 264), in einer Richtung senkrecht zur Ebene des Chips, unter einer Unterseite der zentralen Rippe, die der Klebegrenzfläche (40) zugewandt ist, gelegen ist und von dieser Unterseite durch einen Abstand zwischen 0 und 500 nm getrennt ist.

3. Photonischer Chip nach Anspruch 2, bei dem:
- die Dicke der zentralen Rippe (142) weniger als 300 nm beträgt und
- der erste vergrabene elektrische Kontakt (264) in direktem mechanischem Kontakt mit dieser zentralen Rippe ist.

4. Photonischer Chip nach Anspruch 2, bei dem der erste vergrabene elektrische Kontakt (148C) von der Unterseite der zentralen Rippe (142) durch einen Abstand zwischen 10 nm und 500 nm getrennt ist.

5. Photonischer Chip nach einem der vorhergehenden Ansprüche, bei dem:
- der Wellenleiter (76) eine zentrale Rippe (142), mindestens einen seitlichen Vorsprung (144A, 144B) und mindestens einen Rand (146A, 146B), der den seitlichen Vorsprung mit der zentralen Rippe verbindet, umfasst, wobei die Dicke des Rands mindestens zwei Mal kleiner als die Dicke der zentralen Rippe ist, und
- der erste vergrabene elektrische Kontakt (148A, 148B) in direktem mechanischem Kontakt auf einer Unterseite des seitlichen Vorsprungs ist, wobei diese Unterseite des seitlichen Vorsprungs der Klebegrenzfläche (40) zugewandt ist.

6. Photonischer Chip nach einem der vorhergehenden Ansprüche, bei dem der größte Durchmesser der metallischen Durchkontaktierungen (140) des Verbindungsgitters kleiner als 3 µm ist.

7. Photonischer Chip nach einem der vorhergehenden Ansprüche, bei dem:
- der Träger (36) eine Verbindungsschicht ist,
- das Substrat einen elektrischen Anschluss umfasst, der aus der Gruppe gewählt ist, die aus einem zweiten elektrischen Kontakt (74; 212) besteht, der im Inneren der optischen Schicht (38; 202) vergraben ist, wobei dieser zweite vergrabene elektrische Kontakt der einer optischen Komponente (72) oder einer elektronischen Komponente (210) ist, und aus einer Leiterbahn (106, 108; 276, 280), die auf der Oberseite des Substrats ausgeführt ist,
- der photonische Chip umfasst:
• elektrische Anschlusspads, die auf der Unterseite (34) des Substrats ausgeführt sind, wobei jedes dieser Pads geeignet ist, über eine Lötperle (152-154) elektrisch mit einem anderen Träger (14) verbunden zu werden,
• eine Primärdurchkontaktierung (50-52), die sich durch die Verbindungsschicht hindurch von der Unterseite (34) aus erstreckt, um eines der Anschlusspads elektrisch mit dem elektrischen Anschluss zu verbinden, wobei diese Primärdurchkontaktierung einen Durchmesser größer oder gleich 10 µm hat,
und bei dem:
- die Dicke der optischen Schicht (38; 202) weniger als 15 µm beträgt,
- die Primärdurchkontaktierung (50-52) sich durch die Verbindungsschicht hindurch nur zwischen der Unterseite (34) und der Klebegrenzfläche (40) erstreckt, so dass die Primärdurchkontaktierung nicht in das Innere der optischen Schicht (38; 202) verlängert wird, und
- der photonische Chip eine Sekundärdurchkontaktierung (100, 102, 130; 204; 252, 254, 258) umfasst, welche die Primärdurchkontaktierung im Inneren der optischen Schicht verlängert, um die Primärdurchkontaktierung elektrisch mit dem elektrischen Anschluss zu verbinden, wobei sich diese Sekundärdurchkontaktierung im Inneren der optischen Schicht (38; 202) von der Klebegrenzfläche (40) aus bis zum elektrischen Anschluss erstreckt, wobei der maximale Durchmesser dieser Sekundärdurchkontaktierung weniger als 3 µm beträgt.

8. Photonischer Chip nach Anspruch 7, bei dem die Durchkontaktierung, die sich im Inneren der optischen Schicht von der Klebegrenzfläche (40) aus bis zum ersten vergrabenen elektrischen Kontakt (148A, 148B, 148C; 264) des Wellenleiters (76; 276) erstreckt, von jeder Primärdurchkontaktierung elektrisch isoliert ist.

9. Photonischer Chip nach einem der vorhergehenden Ansprüche, bei dem:
- der Wellenleiter (76) mindestens eines der folgenden Elemente umfasst:
• eine zentrale Rippe (142),
• einen seitlichen Rand (146A, 146B), der mechanisch mit der zentralen Rippe verbunden ist, wobei die Dicke des seitlichen Rands mindestens zwei Mal geringer als die Dicke der zentralen Rippe ist, und
• einen seitlichen Vorsprung (144A, 144B), der mit der zentralen Rippe (142) durch den seitlichen Rand (146A, 146B) verbunden ist, und
- der erste elektrische Kontakt, in einer Richtung senkrecht zur Ebene des Chips, weniger als 500 nm von der zentralen Rippe (142) oder vom Rand (146A, 146B) oder vom seitlichen Vorsprung (144A, 144B) gelegen ist.

10. Verfahren zur Herstellung eines photonischen Chips nach einem der vorhergehenden Ansprüche, **dadurch gekennzeichnet, dass** das Verfahren die folgenden Schritte umfasst:
- Bereitstellen (160) mindestens eines Teils der optischen Schicht (38; 202), die an einem ersten Griff (164) mit einer Dicke von mehr als 250 µm fixiert ist, wobei der mindestens eine Teil der optischen Schicht (38; 202) nacheinander, mit zunehmender Entfernung vom ersten Griff, aufeinander folgend umfasst:
• eine Oxidteilschicht (90),
• eine Kapselungsteilschicht (122) und
• eine erste Klebeseite,
wobei der mindestens eine Teil der optischen Schicht (38; 202) auch umfasst:
• einen Wellenleiter (76; 276), der auf der Seite der Oxidteilschicht (90) ausgeführt ist, die der Seite der ersten Klebegrenzfläche zugewandt ist, und in ein dielektrisches Material der Kapselungsteilschicht gekapselt ist, wobei dieser Wellenleiter einen ersten elektrischen Kontakt umfasst, der im Inneren der Kapselungsteilschicht (122) vergraben ist,
• ein Verbindungsmetallgitter, das eine Durchkontaktierung bildet, die sich im Inneren der Kapselungsteilschicht von der ersten Klebeseite aus bis zum ersten vergrabenen elektrischen Kontakt des Wellenleiters erstreckt, wobei dieses Verbindungsmetallgitter metallische Durchkontaktierungen (140) umfasst, die Metallleitungen elektrisch untereinander verbinden, die sich hauptsächlich parallel zur Ebene des Chips erstrecken, wobei diese Metallleitungen im Inneren der Kapselungsteilschicht übereinander angeordnet sind,
- Bereitstellen (162) des Trägers (36) mit einer Dicke von mehr als 50 µm, der an einem zweiten Griff (170) mit einer Dicke von mehr als 250 µm fixiert ist, wobei dieser Träger umfasst:
• eine zweite Klebeseite (172) auf der Seite, die zu dem zweiten Griff entgegengesetzt ist, und
• wobei dieser Träger frei von optischen Komponenten ist, dann
- Kleben (174) der ersten Klebeseite auf die zweite Klebeseite, um die Klebegrenzfläche (40) zu erhalten, dann
- Entfernen (176) des ersten Griffs, um die Oxidschicht (90) des mindestens einen Teils der optischen Schicht bloßzulegen, dann
- Ausführen (178) eines verstärkenden Teils für das Licht einer Laserquelle auf dieser bloßgelegten Oxidteilschicht (90), wobei diese Laserquelle den Wellenleiter umfasst.

## Claims

1. Photonic chip that lies essentially in a plane called the "plane of the chip", this photonic chip comprising:
- a substrate (30) having upper and lower faces (32, 34) parallel to the plane of the chip, this substrate comprising, between the upper and lower faces:
• a carrier (36) of thickness larger than 50 µm, this carrier being devoid of optical component,
• an optical layer (38; 202) bonded, via a bonding interface (40), to the carrier (36), this optical layer comprising, in succession, from the upper face to the bonding interface (40):
- an oxide sublayer (90), and
- an encapsulating sublayer (122),
• a laser source (70; 256) buried in the optical layer (38; 202), this laser source comprising a waveguide (76; 276) that is formed on the side of the oxide sublayer (90) which faces the bonding interface (40) and that is encapsulated in a dielectric material of the encapsulating sublayer, this waveguide comprising a first electrical contact (148A, 148B, 148C; 264) embedded in the encapsulating sublayer (122),
**characterized in that** the photonic chip comprises an interconnect metal network forming a via (158A, 158B, 158C; 266) that extends, in the optical layer (38; 202), from the bonding interface (40) to the first embedded electrical contact (148A, 148B, 148C; 264) of the waveguide, this interconnect metal network comprising metal vias (140) that electrically connect to one another metal lines that extend mainly parallel to the plane of the chip, these metal lines being arranged one above the other within the optical layer (38; 202).

2. Photonic chip according to Claim 1, wherein:
- the waveguide (76; 276) comprises a central rib (142), and
- the first embedded electrical contact (148C; 264) is located, in a direction perpendicular to the plane of the chip, under a lower face of the central rib which faces the bonding interface (40) and is separated from this lower face by a distance comprised between 0 nm and 500 nm.

3. Photonic chip according to Claim 2, wherein:
- the thickness of the central rib (142) is smaller than 300 nm, and
- the first embedded electrical contact (264) makes direct mechanical contact with this central rib.

4. Photonic chip according to Claim 2, wherein the first embedded electrical contact (148C) is separated from the lower face of the central rib (142) by a distance comprised between 10 nm and 500 nm.

5. Photonic chip according to any one of the preceding claims, wherein:
- the waveguide (76) comprises a central rib (142), at least one lateral protuberance (144A, 144B) and at least one rim (146A, 146B) connecting the lateral protuberance to the central rib, the thickness of the rim being at least two times smaller than the thickness of the central rib, and
- the first embedded electrical contact (148A, 148B) makes direct mechanical contact with a lower face of the lateral protuberance, this lower face of the lateral protuberance facing the bonding interface (40).

6. Photonic chip according to any one of the preceding claims, wherein the maximum diameter of the metal vias (140) of the interconnect network is smaller than 3 µm.

7. Photonic chip according to any one of the preceding claims, wherein:
- the carrier (36) is an interconnect layer,
- the substrate comprises an electrical terminal chosen from the group consisting of a second electrical contact (74; 212) embedded in the optical layer (38; 202), this second embedded electrical contact being that of an optical component (72) or of an electronic component (210), and an electrical track (106, 108; 276, 280) produced on the upper face of the substrate,
- the photonic chip comprises:
• electrical connection pads produced on the lower face (34) of the substrate, each of these pads being able to be electrically connected by way of a solder bump (152-154) to another carrier (14),
• a primary via (50-52) extending through the interconnect layer from the lower face (34) so as to electrically connect one of the connection pads to the electrical terminal, this primary via having a diameter larger than or equal to 10 µm,
and wherein:
- the thickness of the optical layer (38; 202) is smaller than 15 µm,
- the primary via (50-52) extends through the interconnect layer solely between the lower face (34) and the bonding interface (40) and hence the primary via does not extend into the optical layer (38; 202), and
- the photonic chip comprises a secondary via (100, 102, 130; 204; 252, 254, 258) that extends the primary via into the optical layer so as to electrically connect the primary via to the electrical terminal, this secondary via extending in the optical layer (38; 202) from the bonding interface (40) to the electrical terminal, the maximum diameter of this secondary via being smaller than 3 µm.

8. Photonic chip according to Claim 7, wherein the via that extends, in the optical layer, from the bonding interface (40) to the first embedded electrical contact (148A, 148B, 148C; 264) of the waveguide (76; 276) is electrically isolated from each and every primary via.

9. Photonic chip according to any one of the preceding claims, wherein:
- the waveguide (76) comprises at least one of the following elements:
• a central rib (142),
• a lateral rim (146A, 146B) that is mechanically connected to the central rib, the thickness of the lateral rim being at least two times smaller than the thickness of the central rib, and
• a lateral protuberance (144A, 144B) that is connected to the central rib (142) by the lateral rim (146A, 146B), and
- the first electrical contact is located, in a direction perpendicular to the plane of the chip, at less than 500 nm from the central rib (142) or from the rim (146A, 146B) or from the lateral protuberance (144A, 144B).

10. Process for fabricating a photonic chip according to any one of the preceding claims, **characterized in that** the process comprises the following steps:
- providing (160) at least one portion of the optical layer (38; 202) fastened to a first handle (164) of thickness larger than 250 µm, said at least one portion of the optical layer (38; 202) comprising in succession, with distance from the first handle:
• an oxide sublayer (90), and
• an encapsulating sublayer (122), and
• a first bonding face,
said at least one portion of the optical layer (38; 202) also comprising:
• a waveguide (76; 276) that is produced on the side of the oxide sublayer (90) which faces the side of the first bonding interface and that is encapsulated in a dielectric material of the encapsulating sublayer, this waveguide comprising a first electrical contact embedded in the encapsulating sublayer (122),
• an interconnect metal network forming a via that extends, in the encapsulating sublayer, from the first bonding face to the first embedded electrical contact of the waveguide, this interconnect metal network comprising metal vias (140) that electrically connect together metal lines that extend mainly parallel to the plane of the chip, these metal lines being arranged one above the other within the encapsulating sublayer,
- providing (162) the carrier (36) of thickness larger than 50 µm fastened to a second handle (170) of thickness larger than 250 µm, this carrier comprising:
• a second bonding face (172) on the side opposite to the second handle, and
• the carrier being devoid of optical component, then
- bonding (174) the first bonding face to the second bonding face to obtain the bonding interface (40), then
- removing (176) the first handle to expose the oxide sublayer (90) of said at least one portion of the optical layer, then
- producing (178) a portion for amplifying the light of a laser source on this exposed oxide sublayer (90), this laser source comprising the waveguide.
